# EUROPÄISCHE PATENTSCHRIFT

(11) **EP 0 619 648 B1**
(45) Veröffentlichungstag und Bekanntmachung des Hinweises auf die Patenterteilung: **23.08.2000**
(21) Anmeldenummer: 94103657.6
(22) Anmeldetag: 10.03.1994
(51) Int. Cl.: H03G 3/34, H04H 1/00

(54) **Schaltungsanordnung zur Dämpfung eines digitalen Audiosignals während des Auftretens von kurzzeitigen Störungen**
Circuit for the attenuation of a digital audio signal during short disturbances
Circuit d'atténuation d'un signal numérique audio lors de pertubations de courte durée

(30) Priorität: 03.04.1993 DE 4310985
(43) Veröffentlichungstag der Anmeldung: 12.10.1994
(73) Patentinhaber: Blaupunkt-Werke GmbH, D-31139 Hildesheim (DE)
(72) Erfinder: Matthias, Herrmann, Dr., D-31141 Hildesheim (DE)

(56) Entgegenhaltungen:
- EP-A- 0 497 115
- DE-A- 4 039 117
- US-A- 4 434 325
- US-A- 4 593 392
- US-A- 4 947 440
- PATENT ABSTRACTS OF JAPAN vol. 16, no. 392 (E-1251) 20. August 1992 & JP-A-04 129 311 (MATSUSHITA ELECTRIC)

## Beschreibung

Die Erfindung betrifft eine Schaltungsanordnung zur Dämpfung eines digitalen Audiosignals während des Auftretens von kurzzeitigen Störungen, insbesondere während eines vorübergehenden probehalber Empfangs eines anderen Senders.

Insbesondere durch die Einführung des Radio-Daten-Systems, bei dem zusätzlich zu den Audiosignalen Daten übertragen werden, wird es möglich, während des Empfangs eines Rundfunksenders kurzfristig auf eine andere Frequenz umzuschalten, um zu überprüfen, ob das gleiche Programm auf dieser anderen Frequenz günstiger empfangen werden kann. Während des probehalber Empfangs tritt eine Störung des Audiosignals auf, die beispielsweise etwa 25 ms dauert.

Aus Patent Abstracts of Japan, Volume 16, No. 392 (E-1251), 20.08.1992 & JP-A-04 129 311 ist eine Mute-Schaltung bekannt, bei der Knackgeräusche im zu unterbrechenden Signal im Zuge eines Mute-Vorgangs dadurch vermieden werden, daß ein allmählich ansteigender bzw. abfallender Faktor generiert wird, mit dem das zu unterbrechende digitale Signal multipliziert wird. Durch Multiplikation mit dem zeitlich veränderlichen Faktor wird ein allmähliches Aus- bzw. Einblenden des digitalen Signals ermöglicht.

Weiterhin ist aus der DE-A-40 39 117 ein RDS-Rundfunkempfänger bekannt, bei dem auf einen sogenannten Stationsauswahlbefehl die Wiedergabe eines Audiosignals stumm geschaltet, aus einem Sendefrequenzspeicher eine zu einer aktuell am Empfänger eingestellten Sendefrequenz alternative Sendefrequenz probehalber eingestellt, auf ihre Empfangsfeldstärke und/oder ihren Programminhalt überprüft, und bei positivem Prüfergebnis die Stummschaltung beendet und somit das Audiosignal der alternativen Frequenz wiedergegeben wird. Die Stummschaltung erfolgt dabei im Sinne eines harten Aus- bzw. Wiedereinschaltens des Audiosignals.

Aufgabe der vorliegenden Erfindung ist es, eine Schaltungsanordnung anzugeben, welche zur Unterdrückung von kurzzeitigen Störungen das Audiosignal dämpft, ohne dabei weitere Störungen ( 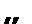 Knackgeräusche" ) zu erzeugen. Die erfindungsgemäße Schaltungsanordnung soll insbesondere für die digitale Signalverarbeitung geeignet sein.

Diese Aufgabe wird erfindungsgemäß dadurch gelöst, daß das Audiosignal mit einem Faktor multipliziert wird, der vor dem Auftreten einer Störung nach einer vorgegebenen Zeitfunktion von einem Maximalwert auf einen Minimalwert und nach der Störung wieder auf den Maximalwert gebracht wird, wobei die Dämpfung im logarithmischen Maßstab beginnend mit dem Maximalwert des Faktors zunächst flach und dann zunehmend steiler und beginnend mit dem Minimalwert, zunächst steil und dann zunehmend flacher verläuft. Durch diesen Verlauf läßt sich ein weitgehend 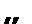 knackfreies" Muten erreichen.

Mit der erfindungsgemäßen Schaltungsanordnung können auch andere kurzzeitige Störungen ausgeblendet werden. Alle Signale und Signalverarbeitungsschritte sind zeit- und wertdiskret (digital), so daß sich die Schaltungsanordnung in vorteilhafter Weise in einem weitgehend digitalen Rundfunkempfänger eignet.

Eine Weiterbildung der Erfindung besteht darin, daß zur Ableitung des Faktors ein Integrator vorgesehen ist, der vorzugsweise aus einem Addierer und einer Verzögerung von vorzugsweise einer Abtastperiode besteht.

Eine vorteilhafte Ausgestaltung dieser Weiterbildung ist dadurch gekennzeichnet, daß dem Addierer eine jeweils ein Integrationsinkrement darstellende Größe und der abgeleitete Faktor aus der vorangegangenen Abtastperiode zuführbar sind, daß das Ausgangssignal des Addierers um eine Abtastperiode verzögert einem Eingang eines Multiplizierers und einem Eingang eines Komparators zuführbar ist, wobei ein anderer Eingang des Komparators mit einer Konstanten, welche den Minimalwert darstellt, beaufschlagbar ist, und daß ein Ausgang des Komparators mit einem weiteren Eingang des Multiplizierers verbunden ist, wobei am Ausgang des Multiplizierers der abgeleitete Faktor ansteht.

Eine andere Weiterbildung der Erfindung besteht darin, daß das Vorzeichen eines Integrationsinkrementes mit Hilfe eines zugeführten Steuersignals steuerbar ist. Dadurch wird eine einfache Ansteuerung der erfindungsgemäßen Schaltungsanordnung möglich. Es ist lediglich ein Steuersignal erforderlich, das rechtzeitig vor Beginn einer zu erwartenden Störung einen ersten Signalsprung und am Ende der Störung einen zweiten Signalsprung aufweist.

Wenn gemäß einer anderen Weiterbildung die Größe eines Integrationsinkrementes mit Hilfe eines weiteren zugeführten Steuersignals umschaltbar ist, kann außer dem schnellen Erhöhen und Verringern der Dämpfung auch eine langsamere Steuerung erfolgen, beispielsweise bei einem Wechsel der Signalquelle.

Bei einem Stereo-Rundfunkempfänger ist vorzugsweise vorgesehen, daß das Audiosignal eines linken Stereo-Kanals und das Audiosignal eines rechten Stereo-Kanals mit dem Faktor multipliziert werden.

Ausführungsbeispiele der Erfindung sind in der Zeichnung anhand mehrerer Figuren dargestellt und in der nachfolgenden Beschreibung näher erläutert. Es zeigt:
- Fig. 1: als Blockschaltbild ein Ausführungsbeispiel der Erfindung und
- Fig. 2: eine logarithmische Darstellung des Verlaufs des Faktors und damit der Dämpfung des Audiosignals.

Die erfindungsgemäße Schaltungsanordnung kann auf verschiedene Weise verwirklicht werden. So können beispielsweise einzelne oder Gruppen der dargestellten Blöcke durch geeignete Schaltungen, insbesondere integrierte Schaltungen, realisiert werden. Bei sehr hohem Integrationsgrad ist es ferner möglich, die gesamte digitale Signalverarbeitung des Empfängers in einem integrierten Schaltkreis zu realisieren, wobei Signalverarbeitungsschritte, wie beispielsweise Filterungen oder nichtlineare Wichtungen, durch Rechenoperationen durchgeführt werden. Innerhalb eines integrierten Schaltkreises können zur Realisierung eines Empfängers mit der erfindungsgemäßen Schaltungsanordnung auch digitale Signalprozessoren und andere digitale Schaltungen, wie beispielsweise Schieberegister, Flip-Flops usw., gemeinsam angeordnet sein.

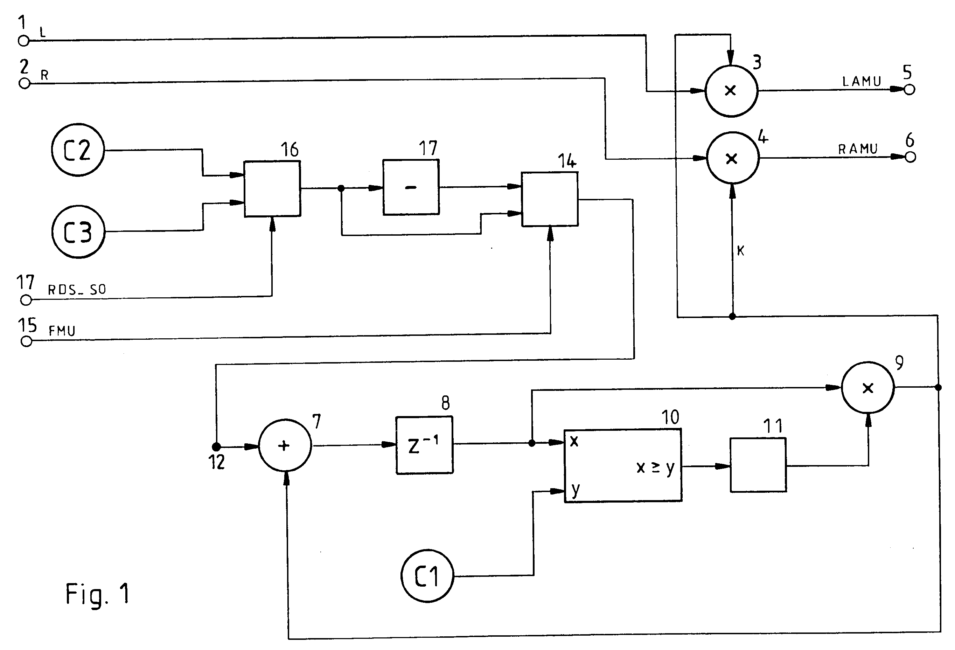

Der Schaltungsanordnung nach Fig. 1 sind die Audiosignale L (links) und R (rechts) über Eingänge 1, 2 zuführbar. Nach Passieren jeweils eines Multiplizierers 3, 4 können die bei Bedarf gedämpften Audiosignale LAMU und RAMU Ausgängen 5, 6 entnommen werden. Den Multiplizierern 3, 4 wird ein Faktor K zugeführt, der im Normalfall einen Maximalwert von 1 aufweist und zum Ausblenden (Muting) auf einen Minimalwert von 0 gebracht wird. Dabei erfolgt der Übergang nach einer vorgegebenen Zeitfunktion, so daß durch den Übergang selbst keine Knackgeräusche entstehen.

Zur Ableitung des Faktors K ist ein Integrator vorgesehen, der im wesentlichen aus einem Addierer 7 und einer Verzögerung 8 um eine Abtastperiode besteht. Der Ausgangswert der Verzögerung 8 wird im folgenden als Integrationswert bezeichnet und über einen weiteren Multiplizierer 9 geleitet, bei dem eine Multiplikation mit 1 oder mit 0 stattfindet. Im Falle der Multiplikation mit 1 entspricht der Faktor K dem Integrationswert, während im Falle einer Multiplikation mit 0 der Faktor K = 0 wird. Letzteres ist erforderlich, um den Faktor K auf 0 zu halten, wenn der Integrationswert negative Werte annehmen sollte. Dazu wird der Integrationswert einem Eingang eines Komparators 10 zugeführt, an dessem weiteren Eingang eine den Minimalwert darstellende Konstante C1 anliegt - bei einem Minimalwert von 0 ist dann C1 = 0. Der Ausgang x≥y des Komparators 10, der ein Ein-Bit-Signal führt, ist dann über einen Formatwandler 11 zur Umwandlung in ein 16-Bit-Signal mit dem Multiplizierer 9 verbunden. Die obere Begrenzung des Faktors K auf den Maximalwert ist in Fig. 1 nicht dargestellt. Sie ist ähnlich wie die Begrenzung auf den Minimalwert realisierbar.

Das bei 12 dem Addierer 7 zugeführte Integrationsinkrement kann zum Verringern und zum Vergrößern des Faktors K mit verschiedenen Vorzeichen versehen werden. Dazu ist ein Negierer 13 und ein Umschalter 14 vorgesehen, der von einem Steuersignal FMU steuerbar ist, das einem Eingang 15 zuführbar ist.

Mit einem weiteren Umschalter 16, der mit Hilfe eines bei 17 zuführbaren Steuersignals RDS_SO steuerbar ist, können wahlweise zwei verschiedene Integrationsinkremente C2 und C3 verwendet werden. Das eine Integrationsinkrement C2 mit einem Wert von beispielsweise 0,0219 bewirkt eine schnelle Änderung des Faktors K, was für das kurzfristige probehalber Umschalten der Empfangsfrequenz günstig ist. Für andere Fälle des Stummschaltens, beispielsweise während des normalen Sendersuchlaufs oder während einer Umschaltung zwischen verschiedenen Audiosignalquellen, kann eine langsamere Änderung des Signals K erfolgen, wozu das Integrationsinkrement C3 verwendet wird, das beispielsweise einen Wert von 0,000219 aufweist.

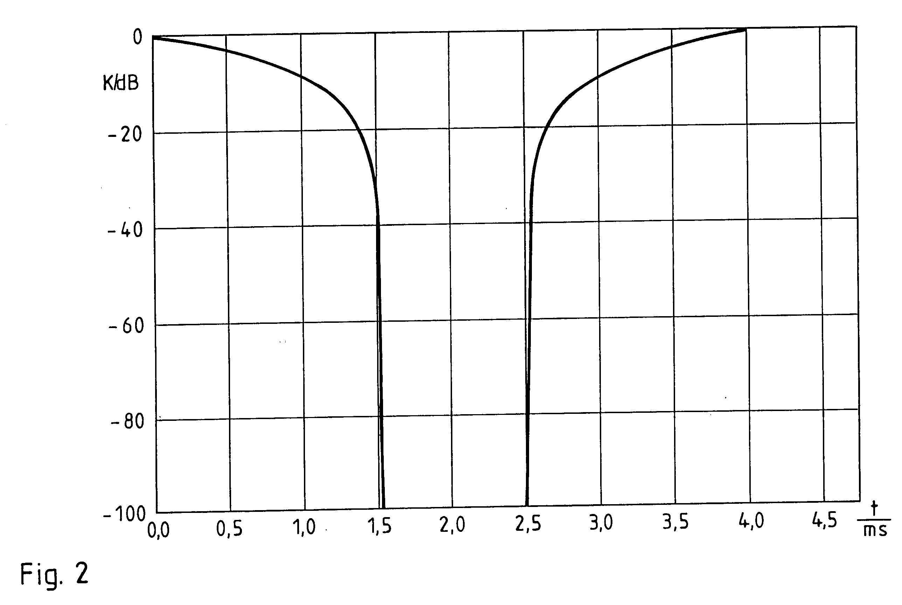

Fig. 2 zeigt ein Ausführungsbeispiel einer Mute-Kurve, wobei auf der Abzisse die Zeit in ms und auf der Ordinate die erzielte Dämpfung im logarithmischen Maßstab in dB dargestellt ist. Zum Zeitpunkt 0 beginnt der Mute-Vorgang und erreicht nach 1,5 ms eine Dämpfung von -40 dB. Der dazu komplementäre Vorgang beginnt zum Zeitpunkt 2,5 ms. Die dargestellte Kurve wird mit einem Integrationsinkrement von 0,0146 erzielt. Besonders vorteilhaft ist der zunächst flache Verlauf der Kurve, um dann sehr steil zu hohen Dämpfungen hin abzufallen. Durch diesen Verlauf läßt sich ein weitgehend "knackfreies" Muten erreichen.

## Patentansprüche

1. Schaltungsanordnung zur Dämpfung eines digitalen Audiosignals während des Auftretens von kurzzeitigen Störungen, insbesondere während eines vorübergehenden probehalben Empfangs eines anderen Senders, dadurch gekennzeichnet, daß das Audiosignal in Multiplizierern (3, 4) mit einem Faktor (k) mulitipliziert wird, welcher Faktor vor dem Auftreten einer Störung nach einer vorgegebenen Zeitfunktion von einem Maximalwert auf einen Minimalwert und nach einer Störung wieder auf den Maximalwert gebracht wird, und daß die Dämpfung im logarithmischen Maßstab beginnend mit dem Maximalwert des Faktors (k) zunächst flach und dann zunehmend steiler und beginnend mit dem Minimalwert zunächst steil und dann zunehmend flacher verläuft.

2. Schaltungsanordnung nach Anspruch 1, dadurch gekennzeichnet, daß zur Bildung des Faktors (k) ein Integrator (7,8) vorgesehen ist.

3. Schaltungsanordnung nach Anspruch 2, dadurch gekennzeichnet, daß der Integrator aus einem Addierer (7) und einer Verzögerung (8) von vorzugsweise einer Abtastperiode besteht.

4. Schaltungsanordnung nach Anspruch 3, dadurch gekennzeichnet, daß dem Addierer (7) eine jeweils ein Integrationsinkrement darstellende Größe und der abgeleitete Faktor (k) aus der vorangegangenen Abtastperiode zuführbar sind, daß das Ausgangssignal des Addierers (7) um eine Abtastperiode verzögert einem Eingang eines Multiplizierers (9) und einem Eingang eines Komparators (10) zuführbar ist, wobei ein anderer Eingang des Komparators (10) mit einer Konstanten, welche den Minimalwert darstellt, beaufschlagbar ist, und daß ein Ausgang des Komparators (10) mit einem weiteren Eingang des Mulitiplizierers (9) verbunden ist, an dessen Ausgang der abgeleitete Faktor (k) ansteht.

5. Schaltungsanordnung nach einem der vorhergehenden Ansprüche, dadurch gekennzeichnet, daß das Vorzeichen eines Integrationsinkrements mit Hilfe eines zugeführten Steuersignals steuerbar ist.

6. Schaltungsanordnung nach einem der vorhergehenden Ansprüche, dadurch gekennzeichnet, daß die Größe eines Integrationsinkrements mit Hilfe eines weiteren zugeführten Steuersignals umschaltbar ist.

7. Schaltungsanordnung nach einem der vorhergehenden Ansprüche, dadurch gekennzeichnet, daß das Audiosignal (L) eines linken Stereo-Kanals und das Audiosignal (R) eines rechten Stereo-Kanals mit dem Faktor (k) multipliziert werden.

## Claims

1. Circuit arrangement for attenuating a digital audio signal while brief disturbances are occurring, in particular during a temporary attempt to receive a different transmitter, characterized in that the audio signal is multiplied in multipliers (3, 4) by a factor (k) which, before a disturbance occurs, is changed from a maximum value to a minimum value in accordance with a predetermined time function and, after a disturbance, is changed back to the maximum value, and in that the attenuation is carried out on a logarithmic scale, starting with the maximum value of the factor (k), initially with a flat profile, and then increasingly more steeply, and starting with the minimum value, initially steeply and then becoming increasingly flatter.

2. Circuit arrangement according to Claim 1, characterized in that an integrator (7, 8) is provided to form the factor (k).

3. Circuit arrangement according to Claim 2, characterized in that the integrator comprises an adder (7) and a delay (8) of preferably one sampling period.

4. Circuit arrangement according to Claim 3, characterized in that a variable which in each case represents an integration increment, and the derived factor (k) from the previous sampling period can be supplied to the adder (7) in that the output signal from the adder (7), can be supplied, delayed by one sampling period, to one input of a multiplier (9) and to one input of a comparator (10), in which case a constant which represents the minimum value can be applied to another input of the comparator (10), and in that one output of the comparator (10) is connected to a further input of the multiplier (9) at whose output the derived factor (k) is present.

5. Circuit arrangement according to one of the preceding claims, characterized in that the mathematical sign of an integration increment can be controlled with the aid of a supplied control signal.

6. Circuit arrangement according to one of the preceding claims, characterized in that the magnitude of an integration increment can be changed with the aid of a further supplied control signal.

7. Circuit arrangement according to one of the preceding claims, characterized in that the audio signal (L) of a left stereo channel and the audio signal (R) of a right stereo channel are multiplied by the factor (k).

## Revendications

1. Circuit pour amortir un signal audio numérique pendant l'arrivée de perturbations brèves notamment pendant la réception provisoire d'échantillonnage d'un autre émetteur
caractérisé en ce que
- le signal audio est multiplié dans des multiplicateurs (3, 4) par un coefficient (k), ce coefficient étant porté d'une valeur maximale à une valeur minimale avant l'apparition d'une perturbation selon une fonction de temps prédéterminée et après une perturbation, il est remis à la valeur maximale, et
- l'amortissement se fait à l'échelle logarithmique, en commençant à la valeur maximale du coefficient (k), tout d'abord à plat puis de manière croissante, et en commençant par la valeur minimale cette variation se fait tout d'abord de manière raide puis de plus en plus plate.

2. Circuit selon la revendication 1,
caractérisé par
un intégrateur (7, 8) pour former le coefficient (k).

3. Circuit selon la revendication 2,
caractérisé en ce que
l'intégrateur se compose d'un additionneur (7) et d'une temporisation (8) de préférence correspondant à une période de détection.

4. Circuit selon la revendication 3,
caractérisé en ce que
- l'additionneur (7) reçoit chaque fois une grandeur représentant un incrément d'intégration et le coefficient dérivé (k) provenant de la période de détection précédente,
- le signal de sortie de l'additionneur (7), retardé d'une période de détection, est appliqué à une entrée d'un multiplicateur (9) et à une entrée d'un comparateur (10),
- une autre entrée du comparateur (10) recevant une constante représentant la valeur minimale, et
- une sortie du comparateur (10) est reliée, à une autre entrée du multiplicateur (9), le coefficient dérivé (k) était disponible à la sortie de ce multiplicateur.

5. Circuit selon l'une des revendications précédentes,
caractérisé en ce que
le signe algébrique d'un incrément d'intégration se commande à l'aide d'un signal de commande qui est appliqué.

6. Circuit selon l'une des revendications précédentes,
caractérisé en ce que
l'amplitude d'un incrément d'intégration se commute à l'aide d'un autre signal de commande appliqué.

7. Circuit selon l'une des revendications précédentes,
caractérisé en ce que
le signal audio (L) est celui du canal stéréo gauche et le signal audio (R) est celui du canal stéréo droit multipliés par le coefficient (k).
